**Europäisches Patentamt**

**European Patent Office**

**Office européen des brevets**

(19)

(11) Veröffentlichungsnummer : **0 169 329**
**B1**

(12) **EUROPÄISCHE PATENTSCHRIFT**

(45) Veröffentlichungstag der Patentschrift :
09.11.88

(21) Anmeldenummer : 85106225.7

(22) Anmeldetag : 21.05.85

(51) Int. Cl.⁴ : **H 05 K 5/06, H 05 K 9/00**

(54) **Flachgehäuse für ein Funkgerät.**

(30) Priorität : 24.05.84 DE 3419416

(43) Veröffentlichungstag der Anmeldung :
29.01.86 Patentblatt 86/05

(45) Bekanntmachung des Hinweises auf die Patenterteilung : 09.11.88 Patentblatt 88/45

(84) Benannte Vertragsstaaten :
AT BE CH DE FR GB IT LI LU NL SE

(56) Entgegenhaltungen :
EP-A- 0 098 587
EP-A- 0 105 717
WO-A-81 /035 98
DE-A- 2 746 221
DE-A- 2 806 186
FR-A- 2 284 247
GB-A- 1 258 485
GB-A- 1 583 021
US-A- 3 091 736

(73) Patentinhaber : Siemens Aktiengesellschaft Berlin und München
Wittelsbacherplatz 2
D-8000 München 2 (DE)

(72) Erfinder : Danielsen, Geir
Haakon Tveters V.10 D
0682 Oslo 6 (NO)
Erfinder : Thomfohrde, Heiner
Flurstrasse 9
D-8021 Hohenschäftlarn (DE)

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf ein Flachgehäuse mit rechteckförmigem Querschnitt für ein Funkgerät, mit einer Öffnung an der Frontseite und einer Öffnung an der Rückseite, welche jeweils mit einer Abdeckung abschließbar sind, mit einer parallel zur Ebene der Öffnungen verlaufenden Bodenplatte, die das Flachgehäuse in zwei wannenförmige Hauptkammern aufteilt, in denen die aus mit Bauteilen bestückten Leiterplatten bestehenden Funkbaugruppen sowie Antennen- und Steuereinrichtungen angeordnet sind, ferner mit in der Bodenplatte eingesetzten Steckverbindungselementen zur elektrischen Verbindung der Einrichtungen in beiden Hauptkammern und mit an den beiden einander gegenüberliegenden Seitenflächen außen angebrachten Führungsschienen zur Aufnahme in eine Halterung. Ein Gehäuse solchen Aufbaus ist aus der DE-A-28 06 186 bekannt.

Ferner ist durch die DE-PS 32 25 627 ein Flachgehäuse bekannt, das sich in Längsrichtung erstreckende Trennwände zur Bildung von Kammern mit Führungen für Leiterplatten genormter Größe und Baugruppen aufweist. Die Abdeckung für die Öffnung der Rückseite besteht aus einem Deckel, die Abdeckung für die Öffnung an der Frontseite aus einem wannenförmig ausgebildeten Kühlkörper mit Kühlrippen an dessen Außenseite und einem Hohlraum an dessen Innenseite, in dem wärmeerzeugende Baugruppen und die interne Verdrahtung angeordnet sind. Der Hohlraum ist mittels einer Rückwand-Leiterplatte abgeschlossen, die an ihrer Außenseite die Steckkontaktelemente für die Verbindung der Leiterplatten untereinander und mit den im Kühlkörper angeordneten Baugruppen enthält.

Aus der WO-A-81/03 598 ist ein Flachgehäuse mit rechteckförmigem Querschnitt für ein Funkgerät bekannt, das eine Hauptkammer und eine auf die wannenförmige Hauptkammer aufgesetzte Abdeckung aufweist, die über ein umlaufend vertieft angeordnetes Dichtungselement mit dem Flachgehäuse kontaktiert und mit dem Flachgehäuse über eine einzige Zentralschraube befestigt ist.

Außerdem ist aus der GB-A-1 583 021 ein Flachgehäuse mit rechteckförmigem Querschnitt bekannt, das einen schwenkbaren Tragebügel aufweist, der bei in eine Halterung eingesetztem Funkgerät zur Verriegelung dient.

Ein Funkgerät, das zur Übertragung von Sprache und Daten sowohl ortsfest als auch im mobilen Einsatz verwendet werden kann, soll möglichst klein und leicht und dabei zugleich robust und HF-, staub- und wasserdicht sein.

Um dem Benutzer die Möglichkeit zu geben, das gleiche Funkgerät an verschiedenen Einsatzorten zu verwenden, ist hierfür eine Einrichtung wünschenswert, die das Funkgerät aufnimmt, gegen unbefugte Entnahme schützt und es ermöglicht, Zusatzeinrichtungen, wie Mithör- und Sprechmöglichkeiten sowie beispielsweise Datengeräte ohne Eingriff in das Funkgerät selbst auf einfache Weise anzubringen.

Der Erfindung liegt die Aufgabe zugrunde, ein Flachgehäuse für ein Funkgerät so auszubilden, daß es die vorstehend genannten Anforderungen erfüllt und eine vielseitige Anwendung und sichere Aufnahme des Funkgerätes ermöglicht.

Diese Aufgabe wird gemäß der Erfindung in der Weise gelöst, daß die auf die wannenförmigen Hauptkammern aufgesetzten Abdeckungen über umlaufend vertieft angeordnete Dichtungselemente mit dem Flachgehäuse kontaktiert und untereinander und mit dem Flachgehäuse über eine einzige Zentralschraube befestigt sind und daß ferner am Flachgehäuse an der Oberseite ein schwenkbarer Tragebügel angebracht ist, der bei in die Halterung eingesetztem Funkgerät zur Verriegelung dient.

Vorteilhafte Ausgestaltungen und Weiterbildungen des Erfindungsgegenstandes sind in den Unteransprüchen angegeben.

Nachstehend wird die Erfindung anhand eines in der Zeichnung dargestellten Ausführungsbeispiels näher erläutert.

Es zeigen

Fig. 1 und 2 eine Ansicht der Rückseite und Vorderseite des bestückten Flachgehäuses bei abgenommenen Abdeckungen,

Fig. 3 das bestückte Flachgehäuse in einer geschnittenen Darstellung,

Fig. 4 eine geschnittene Teildarstellung des Flachgehäuses im Bereich der Bodenplatte,

Fig. 5 die Halterung für das Flachgehäuse,

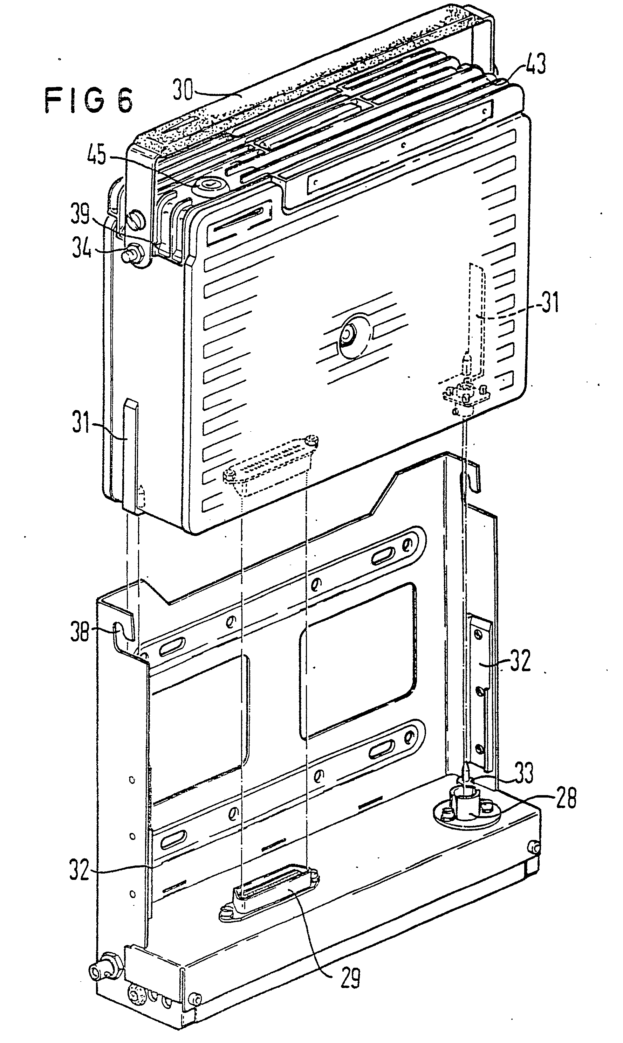

Fig. 6 das montierte Funkgerät mit der Halterung und

Fig. 7 und 8 das montierte Funkgerät in einer Teildarstellung im Bereich des Tragebügels.

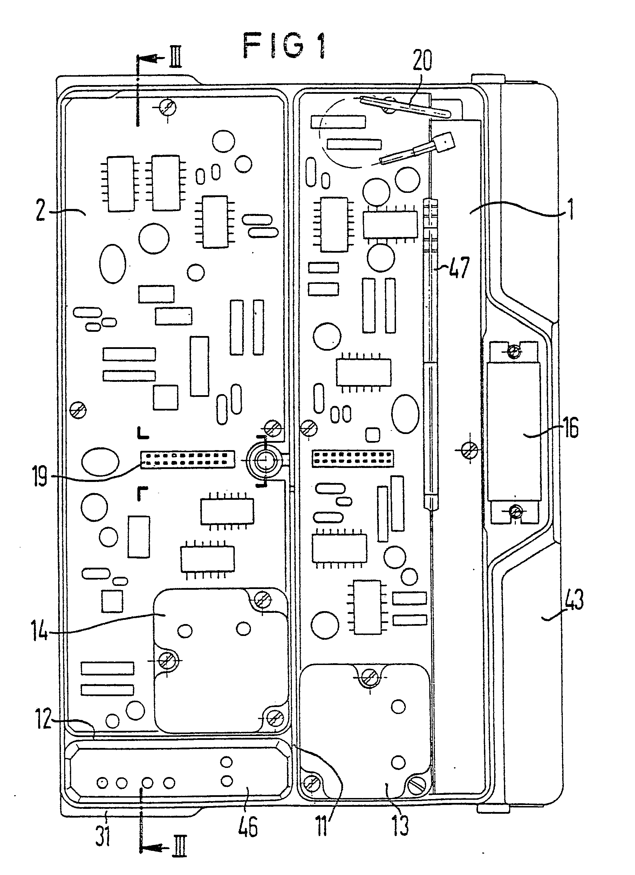

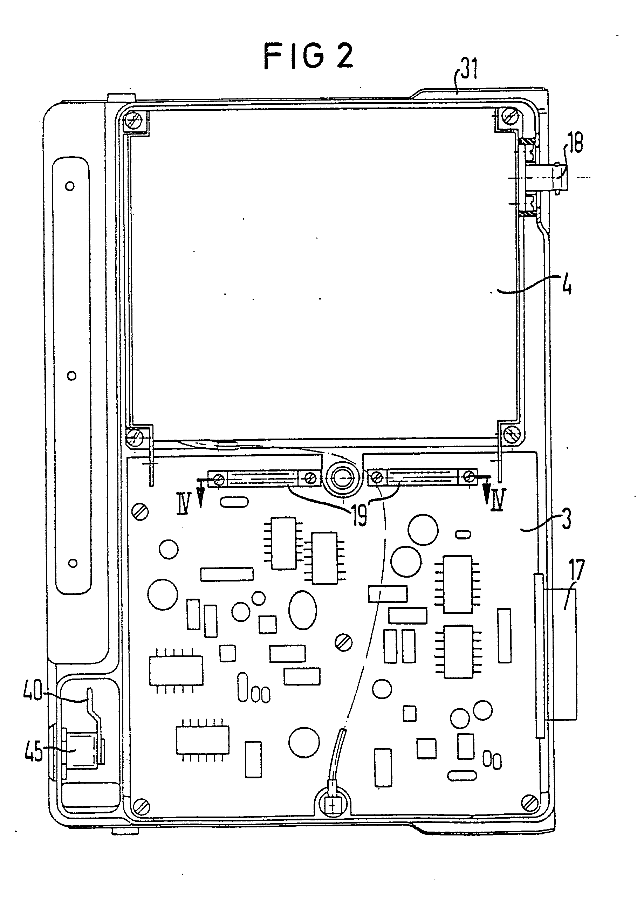

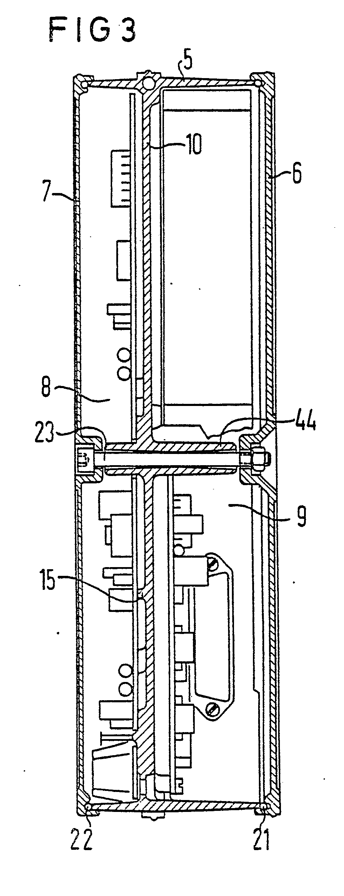

Der Aufbau des Flachgehäuses wird anhand der Fig. 1 bis 3 beschrieben, die das Flachgehäuse in einer Rückansicht und einer Vorderansicht bei abgehobenen Abdeckungen sowie in einem parallel zu den Schmalseiten verlaufenden Schnitt zeigen. Das Flachgehäuse besteht aus einem spritzwasserdichten, robusten Druckgußgehäuse 5 aus Aluminium mit rechteckförmigem Querschnitt, dessen die Frontseite und Rückseite bildende Breitseiten offen sind. Diese Seiten werden durch Deckel 6, 7 abgeschlossen. In einer parallel zu den Deckeln verlaufenden Ebene ist im Innenraum des Flachgehäuses eine mitgegossene Bodenplatte 10 angeordnet, die den Gehäuseinnenraum in zwei flache, wannenförmige Hauptkammern 8, 9 aufteilt. In der in der Figur 3 links der Bodenplatte 10 liegenden, niedrigeren Hauptkammer 8 sind die Funkbaugruppen untergebracht, nämlich der Sender 1 und der Empfänger 2 (siehe Fig. 1). In der gegenüberliegenden Hauptkammer 9 befindet sich die Antennenweiche 4 und eine digitale Steuerung 3 (siehe Fig. 2).

Die Sende- und Empfangsbaugruppe 1, 2 bestehen vorzugsweise aus mit Bauteilen bestückten Leiterplatten. Um die Sende- und Empfangsbaugruppen HF-dicht voneinander zu schirmen, sind zwischen ihnen senkrecht zum Boden eine oder mehrere Trennwände 11, 12 miteingegossen, die zweckmäßigerweise mit aufgesteckten Federelementen 46, 47 Kontakt zur Abdeckung (Deckel 7) herstellen oder direkt abschirmen und die HF-Dichtigkeit verstärken. Für besonders kritische Baugruppen oder Teile von ihnen werden auf der Sende- und/oder Empfangsbaugruppe kleine Druckgußgehäuse 13, 14 auf die Bauteileseite der Leiterplatte aufgesetzt. Die Schirmung auf der Leiterplattenunterseite erfolgt durch Stege 15, die aus dem Gehäusegußboden 10 vorstehen und mit der Schwallseite der Leiterplatte Kontakt vorzugsweise über federnde Elemente herstellen. Um eine maximal günstige Wärmeableitung von heißen Bauteilen zu erreichen, werden diese Bauteile (mit 16 bezeichnetes Bauteil in Fig. 1) in vorteilhafter Weise so angeordnet, daß sie in unmittelbarer Nähe von oder zwischen angegossenen Kühlrippen 43 an der Oberseite des Flachgehäuses kontaktiert werden.

In der zweiten Hauptkammer 9 sind eine digitale Steuerbaugruppe 3 und ein Duplexfilter 4 angeordnet, die jeweils an einen an der Unterseite des Flachgehäuses durch die Gußwand wassergeschützt herausragenden Steckverbinder 17, 18 angeschlossen sind.

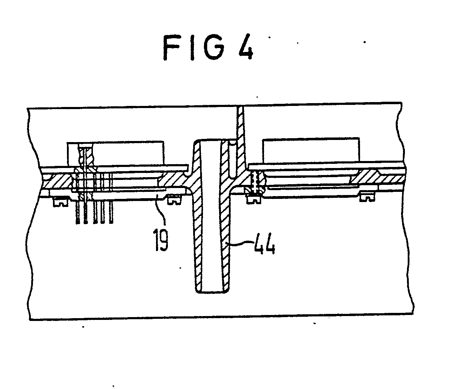

Die elektrischen Verbindungen zwischen den einzelnen Baugruppen beiderseits der Bodenplatte 10 werden für den gewünschten kompakten Aufbau durch zentral liegende Flachstecker 19 hergestellt, die für kürzeste Stromwege sorgen. Die Flachstecker 19 sind beiderseits einer in die Bodenplatte miteingegossenen Führung 44 für eine Zentralschraube 23 in die Bodenplatte 10 eingesetzt (siehe Fig. 4).

Die HF-Verbindungen werden über HF-geschirmte Kabel 20 mit trenn- und lötbaren Kabelenden erzeugt. Die Abschirmung der Baugruppen nach außen erfolgt über die Deckel 6, 7. Die beiden Deckel sind auf die wannenförmigen Hauptkammern 8, 9 aufgesetzt und über umlaufend vertieft angeordnete Dichtungselemente 21, 22 mit dem Flachgehäuse 5 kontaktiert.

Über eine einzige Zentralschraube 23, die in in Vertiefungen der Deckel 6, 7 angeordnete Bohrungen und in die Führung 44 in der Bodenplatte eingreift, werden die Deckel mit dem Gehäuse 10 kontaktiert und untereinander und mit dem Gehäuse 10 befestigt. Um einen ausreichenden Kontakt herzustellen, werden die Deckel 6, 7 vorgespannt. Die Zentralschraube 23 ist so ausgeformt, daß sie mit einer Plombe versiegelt werden kann, um ein unbefugtes Öffnen zu verhindern.

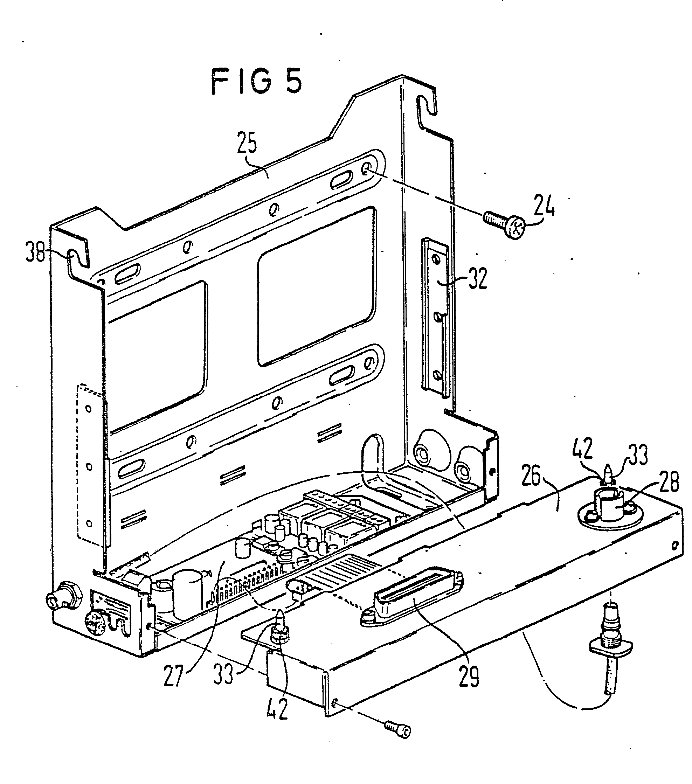

An den einander gegenüberliegenden Schmalseiten des Flachgehäuses 5 sind im unteren Bereich Führungsschienen 31 angebracht, vorzugsweise mitangegossen. Diese sind vorgesehen zur Aufnahme des Funkgerätes in einer Halterung, die entsprechend den Führungsschienen angeordnete und konisch ausgebildete Führungsnuten 32 aufweist, die vorzugsweise aus einem elastischen Material bestehen, um ein Verkratzen der Lackoberfläche zu verhindern und als Dämpfung gegenüber Schwingungen wirken. Diese in Fig. 5 dargestellte Halterung besteht aus einem an drei Seiten abgewinkelten Blech 25, an dessen zwei einander gegenüberliegende abgewinkelten Teilen an der Innenseite die Führungsnuten 32 angeordnet sind und dessen an der dritten Seite angebrachte Abwinkelung so ausgebildet ist, daß sie mit einem zweiten abgewinkelten Blech 26 eine abgeschlossene Kammer bildet. In dieser Kammer sind eine oder mehrere Baugruppen 27 angeordnet. Durch Weglassen oder Hinzufügen von Bauteilen und Steckverbindern wird so die Möglichkeit geschaffen, Zusatzfunktionen wie Mithören über einen Lautsprecher, Anschluß eines Hand-Free-Mikrofons oder Anbringen von Datengeräten ohne Eingriff in das Funkgerät selbst je nach Anwenderwunsch zu ermöglichen. Das Funkgerät kann somit in vielfältiger Weise für unterschiedliche Einsatzorte verwendet werden. Die Befestigung kann in verschiedenen Ebenen an eine Wand oder einen Boden oder im Kofferraum eines Fahrzeuges mit Schrauben 24 erfolgen.

Auf der Oberseite des zweiten, den Kammerabschluß bildenden Bleches 26 sind die Gegenstecker, nämlich der Antennenstecker 28 und Gerätestecker 29 für das Funkgerät so angeordnet, daß sie die Toleranzen der Stecker aufnehmen.

Am Flachgehäuse 5 ist an der Oberseite ein schwenkbarer Tragebügel 30 angebracht. Zum Einsetzen in die Halterung wird der Tragebügel 30 hochgeklappt, das Funkgerät gegen das die Rückwand der Halterung bildende Blech 25 angeschlagen und parallel zur Rückwand eingesetzt. Dabei greifen die seitlich am Flachgehäuse angegossenen Führungsschienen 31 in die Führungsnuten 32 der Halterung. Unmittelbar vor dem Eingriff der Steckverbinder übernehmen zwei auf der Oberseite des zweiten Bleches 26 der Halterung angesetzte Führungsstifte 33 eine Feinjustierung des Funkgerätes zur Halterung, um ein Zerstören der Steckverbinder zu vermeiden. Die Einschubbewegung des Funkgerätes kommt dadurch zum Stillstand, daß zwei am Tragebügel 30 an den abgewinkelten Seitenstegen angebrachte Stifte 34 an der Kante 35 einer Ausnehmung 38 an der Oberseite der abgewinkelten Seitenbleche der Halterung anschlagen.

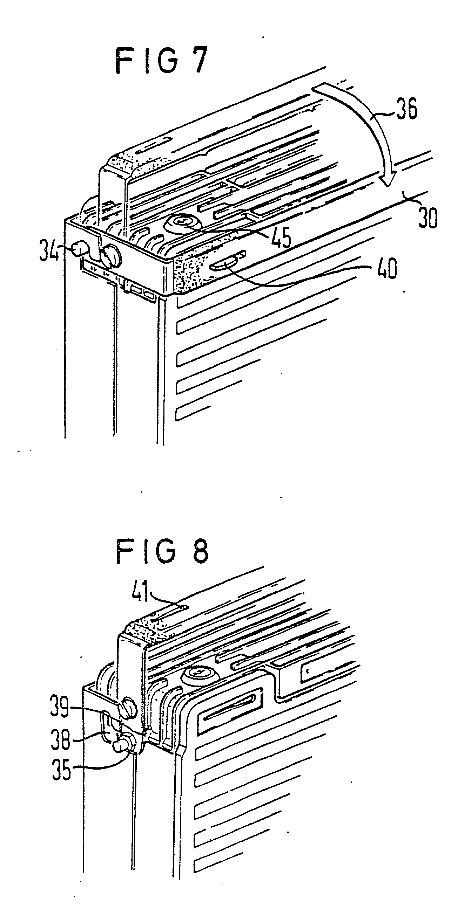

Nun wird der bisher hochgestellte Tragebügel 30 um 90° nach vorne bewegt, wie dies die Teildarstellung in Fig. 7 zeigt. Dabei gleiten die Stifte 34 des Tragebügels 30 auf einer entsprechend ausgebildeten Kurve der Ausnehmung 38 in den abgewinkelten Seitenteilen des Bleches 25. Dabei greifen die Steckverbinder exakt ineinander und die Steckkräfte werden ohne großen Kraftaufwand überwunden. Zwei seitlich am Flachgehäuse angegossene Anschläge 39 verhindern ein unsachgemäßes Umklappen des Tragebügels 30 zur falschen Seite, so daß eine Zerstörung durch Überlastung der Führungen nicht möglich ist.

Am Tragebügel 30 ist im mittleren Teil ein konischer Schlitz 41 angebracht, in den bei heruntergeklapptem Tragebügel der Riegel 40 eines in entsprechender Lage an der Oberseite des Flachgehäuses angebrachten Schlosses 45 eingreift, der mit einem Sicherheitsschlüssel nach vorne gedreht wird. Zwei an den Führungsstiften 33 in der Halterung angebrachte gummiähnliche Puffer 42 drücken dabei das Funkgerät so nach oben, daß der Riegel 40 des Schlosses 45 und die beiden Stifte 34 am Tragebügel 30 gegen entsprechende Widerlager gedrückt werden und ein Spiel zwischen Funkgerät und Halterung vermieden wird.

Die Herausnahme des Gerätes aus der Halterung erfolgt nach dem Aufsperren des Schlosses durch Schwenken des Tragebügels um 90° nach oben. Hierbei werden die Steckkräfte durch die Hebelübersetzung problemlos überwunden und das Funkgerät kann ohne nennenswerten Kraftaufwand aus der Halterung herausgenommen werden.

## Patentansprüche

1. Flachgehäuse mit rechteckförmigem Querschnitt für ein Funkgerät, mit einer Öffnung an der Frontseite und einer Öffnung an der Rückseite, welche jeweils mit einer Abdeckung abschließbar sind, mit einer parallel zur Ebene der Öffnungen verlaufenden Bodenplatte, die das Flachgehäuse in zwei wannenförmige Hauptkammern aufteilt, in denen die aus mit Bauteilen bestückten Leiterplatten bestehenden Funkbaugruppen sowie Antennen- und Steuereinrichtungen angeordnet sind, ferner mit in der Bodenplatte eingesetzten Steckverbindungselementen zur elektrischen Verbindung der Einrichtungen in beiden Hauptkammern und mit an den beiden einander gegenüberliegenden Seitenflächen außen angebrachten Führungsschienen zur Aufnahme in eine Halterung, dadurch gekennzeichnet, daß die auf die wannenförmigen Hauptkammern (8, 9) aufgesetzten Abdeckungen (6, 7) über umlaufend vertieft angeordnete Dichtungselemente (21, 22) mit dem Flachgehäuse (5) kontaktiert und untereinander und mit dem Flachgehäuse über eine einzige Zentralschraube (23) befestigt sind und daß ferner am Flachgehäuse (5) an der Oberseite ein schwenkbarer Tragebügel (30) angebracht ist, der bei in die Halterung eingesetztem Funkgerät zur Verriegelung dient.

2. Flachgehäuse nach Anspruch 1, dadurch gekennzeichnet, daß es aus einem Druckgußgehäuse aus Aluminium besteht.

3. Flachgehäuse nach Anspruch 1 oder 2, dadurch gekennzeichnet, daß die Hauptkammern (8, 9) durch Trennwände (11, 12) unterteilt sind.

4. Flachgehäuse nach Anspruch 3, dadurch gekennzeichnet, daß die Trennwände (11, 12) über aufgesteckte Federelemente Kontakt zu den Abdeckungen herstellen.

5. Flachgehäuse nach einem der Ansprüche 2 bis 4, dadurch gekennzeichnet, daß die Bodenplatte (10) und die Trennwände (11, 12) in das Flachgehäuse miteingegossen sind.

6. Flachgehäuse nach einem der Ansprüche 1 bis 5, dadurch gekennzeichnet, daß die Halterung aus einem mehrseitig abgewinkelten Blech (25) besteht, das an seinem Ende so ausgebildet ist, daß es mit einem zweiten abgewinkelten Blech (26) eine abgeschlossene Kammer bildet, die weitere Baugruppen aufnimmt.

7. Flachgehäuse nach Anspruch 6, dadurch gekennzeichnet, daß die weiteren Baugruppen entsprechend den besonderen Zusatzfunktionen des Funkgerätes ausgebildet sind.

8. Flachgehäuse nach Anspruch 6, dadurch gekennzeichnet, daß an der Oberseite des zweiten Bleches (26) der Halterung Steckverbindungselemente (28, 29) angeordnet sind, die mit entsprechenden weiteren Steckverbindungselementen (17, 18) an der Unterseite des Funkgerätes in Eingriff kommen.

9. Flachgehäuse nach einem der Ansprüche 6 bis 8, dadurch gekennzeichnet, daß an der Innenseite der abgewinkelten Seitenteile des Bleches (25) für die Halterung konisch ausgebildete Führungsnuten (32) angeordnet sind, in die die entsprechend ausgebildeten Führungsschienen (31) des Funkgerätes eingreifen.

10. Flachgehäuse nach Anspruch 9, dadurch gekennzeichnet, daß die Führungsnuten (32) aus elastischem Material bestehen.

11. Flachgehäuse nach einem der Ansprüche 1 bis 10, dadurch gekennzeichnet, daß am Tragebügel (30) an den abgewinkelten, seitlich am Gehäuse anliegenden Enden nach außen gerichtete Stifte (34) angebracht sind, die beim Schwenken des Tragebügels (30) in entsprechenden, kurvenförmig ausgebildeten Schlitzen (38) seitlich im Halterungsblech (25) geführt sind.

12. Flachgehäuse nach einem der Ansprüche 1 bis 11, dadurch gekennzeichnet, daß am Tragebügel (30) im mittleren Teil ein konischer Schlitz (41) vorgesehen ist, in den bei in die Halterung eingesetztem Funkgerät und um 90° nach vorn geschwenktem Tragebügel (30) der Riegel (40) eines am Funkgerät angeordneten Schlosses (45) eingreift.

## Claims

1. A flat housing of rectangular cross-section, for a radio apparatus having an opening on the front face and an opening at the rear, each of which can be closed by a respective cover ; a base plate extending parallel to the planes of the openings to divide the flat housing into trough-like main chambers in which are arranged radio assemblies comprising circuit boards assembled with components, antenna and control devices ; and also connecting plug elements inserted in the base plate to electrically connect the devices in the two main chambers, and guide bars each arranged accommodated in a mounting on the exterior of the two opposite sides, characterised in that the covers (6, 7) which are arranged on the trough-like main chambers (8, 9), are contacted via peripheral, recessed sealing elements (21, 22), with the flat housing (5), and are attached to one another and to the flat housing via one single central screw (23), and that moreover, on the upper side of the flat housing (5), there is arranged a pivotable support bracket (30) which is used for locking purposes when the radio apparatus is inserted into the mounting.

2. A flat housing as claimed in Claim 1, characterised in that it consists of a die-cast housing of aluminium.

3. A flat housing as claimed in Claim 1 or 2, characterised in that the main chambers (8, 9) are sub-divided by partition walls (11, 12).

4. A flat housing as claimed in Claim 3, characterised in that the partition walls (11, 12) establish contact with the covers via applied spring elements.

5. A flat housing as claimed in one of Claims 2 to 4, characterised in that the base plate (10) and the partition walls (11, 12) are integrally cast into the flat housing.

6. A flat housing as claimed in one of Claims 1 to 5, characterised in that the mounting consists of a multi-laterally angled metal sheet (25) which is designed at its end such that, together with a second angled metal sheet (26), it forms a closed chamber which accommodates further assemblies.

7. A flat housing as claimed in Claim 6, characterised in that the further assemblies are designed in accordance with the special additional functions of the radio apparatus.

8. A flat housing as claimed in Claim 6, characterised in that on the upper side of the second metal sheet (26) of the mounting are arranged connecting plug elements (28, 29) which engage with corresponding further connecting plug elements (17, 18) on the underneath of the radio apparatus.

9. A flat housing as claimed in one of Claims 6 to 8, characterised in that on the inside of the angled lateral components of the metal sheet (25) for the mounting, there are arranged conical guide grooves (32) into which the correspondingly-designed guide bars (31) of the radio apparatus engage.

10. A flat housing as claimed in Claim 9, characterised in that the guide grooves (32) consist of elastic material.

11. A flat housing as claimed in one of Claims 1 to 10, characterised in that at the angled ends of the support bracket (30) which laterally contact the housing are arranged outwardly-directed pins (34) which, when the support bracket (30) is pivoted, are guided in corresponding, curved-shaped slots (38) arranged laterally in the mounting metal sheet (25).

12. A flat housing as claimed in one of Claims 1 to 11, characterised in that the central part of the support bracket (30) contains a conical slot (41) into which the bolt (40) of a lock (45) arranged on the radio apparatus engages when the radio apparatus is inserted in the mounting and the support bracket (30) is pivoted forwards by 90°.

## Revendications

1. Boîtier plat possédant une section transversale rectangulaire pour un appareil radio, et comportant une ouverture au niveau de la face avant et une ouverture au niveau de la face arrière, ces ouvertures pouvant être fermées par des capots respectifs, une plaque de base parallèle au plan des ouvertures et subdivisant le boîtier plat en deux chambres principales en forme de cuvettes, dans lesquelles sont disposés les modules radioélectriques plats constitués par des plaquettes à circuits imprimés équipés de composants, ainsi que des dispositifs d'antenne et de commande, et en outre des éléments de liaison à enfichage insérés dans la plaque de base et servant à relier électriquement les dispositifs situés dans les deux chambres principales, et des rails de guidage prévus extérieurement sur les deux faces latérales opposées et destinés à être reçus dans un support, caractérisé par le fait que les capots (6, 7) montés sur les chambres principales en forme de cuvettes (8, 9) sont en contact avec le boîtier plat (5) par l'intermédiaire d'organes d'étanchéité (21, 22) ménagés sur la périphérie et sont fixés l'un à l'autre et au boîtier plat par l'intermédiaire d'une vis centrale unique (23), et qu'en outre sur la face supérieure du boîtier plat (5) se trouve disposé un étrier de transport pivotant (30), qui est utilisé pour le verrouillage, lorsque l'appareil radio est inséré dans le support.

2. Boîtier plat suivant la revendication 1, caractérisé par le fait qu'il est réalisé sous la forme d'un boîtier en aluminium moulé sous pression.

3. Boîtier plat suivant la revendication 1 ou 2, caractérisé par le fait que les chambres (8, 9) sont subdivisées par des parois de séparation (11, 12).

4. Boîtier plat suivant la revendication 3, caractérisé par le fait que les parois de séparation (11, 12) établissent, par l'intermédiaire d'éléments de ressorts enfichés sur elles, un contact avec les capots.

5. Boîtier plat suivant l'une des revendications 2 à 4, caractérisé par le fait que la plaque de base (10) et les parois de séparation (11, 12) sont formées conjointement par moulage dans le boîtier plat.

6. Boîtier plat suivant l'une des revendications 1 à 5, caractérisé par le fait que le support est constitué par une tôle (25), qui est coudée de façon multiple et dont une extrémité est agencée de manière à former, avec une seconde tôle coudée (26), une chambre fermée, qui loge d'autres modules.

7. Boîtier plat suivant la revendication 6, caractérisé par le fait que les autres modules sont agencés conformément aux fonctions supplémentaires particulières de l'appareil radio.

8. Boîtier plat suivant la revendication 6, caractérisé par le fait que sur la face supérieure de la seconde tôle (26) du support se trouvent disposés des éléments de liaison à enfichage (28, 29) qui viennent en prise avec d'autres éléments correspondants de liaison à enfichage (17, 18) situés sur la face inférieure de l'appareil radio.

9. Boîtier plat suivant l'une des revendications 6 à 8, caractérisé par le fait que sur la face inférieure des éléments latéraux coudés de la tôle (25) se trouvent disposées des rainures de guidage (32), qui sont conçues avec une forme conique pour le support et dans lesquelles s'engagent les rails de guidage (31), conçus de façon correspondante, de l'appareil radio.

10. Boîtier plat suivant la revendication 9, caractérisé par le fait que les rainures de guidage (32) sont réalisées en un matériau élastique.

11. Boîtier plat suivant l'une des revendications 1 à 10, caractérisé par le fait que sur les extrémités coudées de l'étrier de support (3), qui s'appliquent latéralement contre le boîtier, se trouvent disposés des tétons (34) dirigés vers l'extérieur, qui, lors du pivotement de l'étrier de support (30), sont guidés latéralement dans la tôle de fixation (25) dans des fentes correspondantes (38) de forme courbe.

12. Boîtier plat suivant l'une des revendications 1 à 11, caractérisé par le fait qu'il est prévu dans la partie centrale de l'étrier de support (30) une fente conique (41) dans laquelle le pêne (40) d'un verrou (45) monté sur un appareil radio s'engage lorsque l'appareil radio est inséré dans le support et est que l'étrier de transport (30) est pivoté de 90° vers l'avant.

# FIG 1

# FIG 2

FIG 3

# FIG 4

19   44

# FIG 5

# FIG 6

30

43

45

39

34

31

31

38

32

32

33

28

29

FIG 7

FIG 8